# EUROPÄISCHE PATENTSCHRIFT

(11) **EP 3 120 161 B1**
(45) Veröffentlichungstag und Bekanntmachung des Hinweises auf die Patenterteilung: **30.12.2020**
(21) Anmeldenummer: 15712551.9
(22) Anmeldetag: 16.03.2015
(51) Int. Cl.: G01R 31/52, G01R 27/02, G01R 31/00

(54) **VORRICHTUNG UND VERFAHREN ZUR ÜBERWACHUNG EINER ELEKTRISCHEN ISOLATION BEI EINEM BORDNETZ EINES FAHRZEUGS**
DEVICE AND METHOD FOR MONITORING AN ELECTRICAL INSULATION IN A VEHICLE ELECTRICAL SYSTEM
DISPOSITIF ET PROCÉDÉ SERVANT À SURVEILLER UNE ISOLATION ÉLECTRIQUE D'UN RÉSEAU DE BORD D'UN VÉHICULE

(30) Priorität: 17.03.2014 DE 102014204870
(43) Veröffentlichungstag der Anmeldung: 25.01.2017
(73) Patentinhaber: Vitesco Technologies GmbH, 30165 Hannover (DE)
(72) Erfinder: SCHMELZER, Lars, 93049 Regensburg (DE)
(74) Vertreter: Waldmann, Georg Alexander
(86) Internationale Anmeldenummer: PCT/EP2015/055437
(87) Internationale Veröffentlichungsnummer: WO 2015/140107

(56) Entgegenhaltungen:
- WO-A1-2012/160118
- KR-A- 20130 109 066
- US-A1- 2011 006 777

## Beschreibung

Die Erfindung betrifft eine Vorrichtung und ein Verfahren zur Überwachung einer elektrischen Isolation bei einem Bordnetz eines Fahrzeugs, insb. eines Hybrid-/Elektrofahrzeugs. Ferner betrifft die Erfindung ein Bordnetz für ein Fahrzeug sowie ein Fahrzeug, insb. ein Hybrid-/Elektrofahrzeug, mit einem Bordnetz, wobei das Bordnetz eine oben genannte Vorrichtung umfasst.

Moderne Fahrzeuge, insbesondere Hybrid- oder Elektrofahrzeuge, weisen Bordnetze auf, die einen Hochvoltbordnetzzweig umfasst, in dem eine Betriebsspannung von mehreren hundert Volt herrscht.

Eine Spannung von über 60 Volt ist aber für Menschen, insbesondere für Kinder, lebensgefährlich. Deshalb wird ein Hochvoltbordnetzzweig mit einer Betriebsspannung von mehr als 60 Volt von dem Rest des Bordnetzes bzw. von der Fahrzeugkarosserie elektrisch isoliert, um eine Gefährdung von Menschen auszuschließen.

Bei technischen Defekten im Bordnetz oder bei Bedienfehlern kann ein so genannter Fehlerstrom von dem Hochvoltbordnetzzweig durch menschlichen Körper fließen. Ist die elektrische Isolation zwischen dem genannten Hochvoltbordnetzzweig und dem Rest des Bordnetzes bzw. der Fahrzeugkarosserie dabei intakt und ausreichend hoch, so wird die Stromstärke des Fehlerstromes auf einen für Menschen ungefährlichen Wert begrenzt.

Ist die elektrische Isolation aber nicht ausreichend hoch, so kann ein Fehlerstrom mit einer Stromstärke von mehreren Milliampere durch menschliche Körper fließen, die für Menschen lebensgefährlich sein kann.

Um solche lebensgefährlichen Fehlerströme von vornherein zu vermeiden, ist es erforderlich, die elektrische Isolation im Bordnetz ständig zu überwachen und potentielle Gefahren möglichst frühzeitig zu erkennen.

Daher besteht die Aufgabe der vorliegenden Erfindung darin, eine kostengünstige Möglichkeit zur Überwachung einer elektrischen Isolation bei einem Bordnetz eines Fahrzeugs bereitzustellen.

Überwachungen der elektrischen Isolation sind zum Beispiel aus US 2011/006777 A1, WO 2012/160118 A1 und KR 2013 0109066 A bekannt.

Diese Aufgabe wird durch Gegenstände der unabhängigen Ansprüche gelöst. Vorteilhafte Ausgestaltungen sind Gegenstand der Unteransprüche.

Gemäß einem ersten Aspekt der Erfindung wird eine Vorrichtung zur Überwachung einer elektrischen Isolation bei einem Bordnetz eines Fahrzeugs, insb. eines Hybrid-/Elektrofahrzeugs, geschaffen.

Demnach umfasst die Vorrichtung eine Spannungsquelle, die eingerichtet ist, eine erste Gleichspannung mit einem ersten Spannungswert und eine zweite Gleichspannung mit einem zweiten Spannungswert zu generieren bzw. zu erzeugen.

Die Vorrichtung weist einen Stromanschlusspunkt auf, über den eine positive Stromversorgungsleitung des Bordnetzes, insb. eines Hochvoltbordnetzzweigs des Bordnetzes, und eine negative Stromversorgungsleitung des Bordnetzes bzw. des Hochvoltbordnetzzweigs miteinander elektrisch verbunden bzw. verbindbar sind.

Die Vorrichtung umfasst ferner einen ersten Strompfad zwischen der positiven Stromversorgungsleitung und dem Stromanschlusspunkt, einen zweiten Strompfad zwischen der negativen Stromversorgungsleitung und dem Stromanschlusspunkt, und einen dritten Strompfad zwischen dem Stromanschlusspunkt und der Spannungsquelle.

Die Vorrichtung umfasst zudem zumindest zwei der folgenden drei Strommesseinheiten:
- einer ersten Strommesseinheit in dem ersten Strompfad zum Messen eines ersten, durch den ersten Strompfad fließenden Stromes,
- einer zweiten Strommesseinheit in dem zweiten Strompfad zum Messen eines zweiten, durch den zweiten Strompfad fließenden Stromes,
- einer dritten Strommesseinheit in dem dritten Strompfad zum Messen eines dritten, durch den dritten Strompfad fließenden Stromes.

Außerdem umfasst die Vorrichtung eine Ermittlungseinheit, die über Signaleingänge mit jeweiligem Signalausgang der zumindest zwei der drei Strommesseinheiten elektrisch verbunden ist.

Die Ermittlungseinheit ist eingerichtet, aus ersten Strommesswerten und zweiten Strommesswerten sowie den Spannungswerten der generierten Spannungen einen Isolationswiderstand zwischen dem Bordnetz und elektrischer Masse bzw. zwischen dem Hochvoltbordnetzzweig des Bordnetzes und dem Rest des Bordnetzes zu ermitteln.

Dabei sind die ersten Strommesswerte Stromwerte zweier Ströme, die zu einer ersten Zeitdauer, zu der die Spannungsquelle die erste Gleichspannung generiert, unter Einwirkung der ersten Gleichspannung durch zwei der drei Strompfade fließen. Die Stromwerte dieser beiden Ströme werden von den jeweiligen, in den jeweiligen zwei Strompfaden angeordneten Strommesseinheiten zu der genannten ersten Zeitdauer gemessen und als erste Strommesswerte an die Ermittlungseinheit weitergeleitet.

Analog sind die zweiten Strommesswerte Stromwerte zweier Ströme, die zu einer zweiten Zeitdauer, zu der die Spannungsquelle die zweite Gleichspannung generiert, unter Einwirkung der zweiten Gleichspannung durch die jeweiligen zwei Strompfade fließen. Die Stromwerte dieser beiden Ströme werden von den entsprechenden Strommesseinheiten zu der genannten zweiten Zeitdauer gemessen und als zweite Strommesswerte an die Ermittlungseinheit weitergeleitet.

Unter dem Begriff "Gleichspannung" wird eine Spannung verstanden, die über eine bestimmte Zeitdauer, die für Messung der oben genannten Strommesswerte erforderlich ist, einen konstanten Spannungswert aufweist. Die Spannungsquelle generiert somit Gleichspannungen mit unterschiedlichen jedoch konstanten Spannungswerten.

Zur Überwachung der elektrischen Isolation bei dem Bordnetz, insb. zwischen dem Hochvoltbordnetzzweig und dem Rest des Bordnetzes bzw. der Fahrzeugkarosserie, generiert die Vorrichtung mit der Spannungsquelle in einem bestimmten Zeitabstand mittelbar oder unmittelbar aufeinanderfolgend zwei Gleichspannungen mit unterschiedlichen Spannungswerten. Unter Einwirkung der beiden Gleichspannungen fließen Ströme mit unterschiedlichen Stromwerten durch die drei Strompfade und anschließend von den Strompfaden zu der positiven und der negativen Stromversorgungsleitung des Bordnetzes bzw. des Hochvoltbordnetzzweigs des Bordnetzes.

Ist die elektrische Isolation bei dem Bordnetz, insb. zwischen dem Hochvoltbordnetzzweig und dem Rest des Bordnetzes bzw. der Fahrzeugkarosserie ausreichend hoch, so fließt kein bzw. kaum Strom unter Einwirkung der beiden Gleichspannungen von dem Hochvoltbordnetzzweig bzw. von den beiden Stromversorgungsleitungen zu dem Rest des Bordnetzes bzw. zu der Fahrzeugkarosserie (elektrischer Masse).

Ist das Bordnetz bzw. der Hochvoltbordnetzzweig durch bspw. Defekte im Bordnetz von der Fahrzeugkarosserie nicht ausreichend isoliert, so bildet sich zwischen dem Hochvoltbordnetzzweig und dem Rest des Bordnetzes bzw. zwischen den Stromversorgungsleitungen des Hochvoltbordnetzzweigs und dem Rest des Bordnetzes einen Leckstrompfad, durch den Leckströme unter Einwirkung der beiden Gleichspannungen von dem Hochvoltbordnetzzweig zu dem Rest des Bordnetzes bzw. der Fahrzeugkarosserie fließen.

Mit den beiden Strommesseinheiten kann die Vorrichtung dann Stromwerte der durch die Strompfade fließenden Ströme messen und anhand der gemessenen Stromwerte und der bekannten Spannungswerte der beiden Gleichspannungen den Isolationswiderstand zwischen dem Hochvoltbordnetzzweig und dem Rest des Bordnetzes bzw. der Fahrzeugkarosserie ermitteln.

Der ermittelte Isolationswiderstand kann dann mit einem vorgegebenen Referenzwiderstand verglichen werden. Bei Unterschreiten des Referenzwiderstands durch den ermittelten Isolationswiderstand wird von einem elektrischen Leck zwischen dem Bordnetz und der elektrischen Masse bzw. zwischen dem Hochvoltbordnetzzweig und dem Rest des Bordnetzes oder der elektrischen Masse ausgegangen. Entsprechend werden Warnungen an den Fahrer des Fahrzeugs ausgegeben oder geeignete vorabfestgelegte Maßnahmen, insb. geeignete automatische Maßnahmen, eingeleitet. Zu den möglichen automatischen Maßnahmen gehören bspw. die elektrischen Energiespeicher, wie z. B. Traktionsbatterie, mit Ladespannungen von über 60 Volt von dem Bordnetz elektrisch zu trennen oder zu entladen.

Dabei sind die Strommesseinheiten bspw. mit Shunt-Widerständen oder Hallsensoren mit nachgeschalteten Operationsverstärkern in einfacher Weise kostengünstig realisierbar. Als Spannungsquelle kann bspw. ein einfacher Gleichspannungswandler dienen, der an einem Niedervoltbordnetzzweig des Bordnetzes elektrisch angeschlossen ist und durch Hochsetzen (und ggfs. durch Invertieren) der Betriebsspannung des Niedervoltbordnetzzweigs die beiden Gleichspannungen generiert. Die Ermittlungseinheit kann mit einem einfachen kostengünstigen Mikroprozessor und einem kostengünstigen Analog-Digital-Wandler realisiert werden.

Damit wird eine Vorrichtung bereitgestellt, die mit einfachen kostengünstigen elektrischen/elektronischen Komponenten elektrische Isolation bei einem Bordnetz eines Fahrzeugs, insb. zwischen einem Hochvoltbordnetzzweig und dem Rest des Bordnetzes bzw. der Fahrzeugkarosserie, in einfacher Weise zuverlässig ermitteln kann.

Folglich ist eine kostengünstige Möglichkeit zur zuverlässigen Überwachung einer elektrischen Isolation bei einem Bordnetz eines Fahrzeugs geschaffen.

Gemäß einer bevorzugten Ausgestaltung der Vorrichtung umfasst diese alle drei der oben genannten Strommesseinheiten, wobei die Ermittlungseinheit über drei Signaleingänge mit dem jeweiligen Signalausgang der drei Strommesseinheiten elektrisch verbunden ist. Dabei dienen die dritte Strommesseinheit bzw. deren Strommesswerte zur Überprüfung des ermittelten Isolationswiderstands und ermöglichen somit eine noch zuverlässige Überwachung der elektrischen Isolation bei dem Bordnetz.

Gemäß einer weiteren bevorzugten Ausgestaltung der Vorrichtung umfasst diese in dem ersten Strompfad einen ersten Widerstand zum Begrenzen des ersten und/oder des dritten Stromes. Vorzugsweise umfasst die Vorrichtung in dem zweiten Strompfad einen zweiten Widerstand zum Begrenzen des zweiten und/oder des dritten Stromes. Dabei sind die beiden Widerstände hochohmig ausgeführt. Vorzugsweise weisen die beiden Widerstände Widerstandswerte auf, die im Mega-Ohm Bereich liegen.

Gemäß noch einer weiteren bevorzugten Ausgestaltung der Vorrichtung umfasst diese in dem ersten Strompfad einen ersten steuerbaren Schalter zum Unterbrechen oder Herstellen elektrischer Verbindung in dem ersten Strompfad. Alternativ oder zusätzlich zu dem ersten Schalter in dem ersten Strompfad umfasst die Vorrichtung in dem zweiten Strompfad einen zweiten steuerbaren Schalter zum Unterbrechen oder Herstellen elektrischer Verbindung in dem zweiten Strompfad. Durch gesteuertes Öffnen dieser beiden steuerbaren Schalter kann die Vorrichtung in der Zeit, in der keine Überwachung der elektrischen Isolation bei dem Bordnetz stattfindet, von dem Bordnetz elektrisch getrennt werden. Nur bei Bedarf, nämlich bei Überwachung der elektrischen Isolation, kann die Vorrichtung durch gesteuertes Schließen der beiden Schalter an das Bordnetz elektrisch angeschlossen werden. Gemäß noch einer weiteren bevorzugten Ausgestaltung der Vorrichtung ermittelt diese den Isolationswiderstand R_ISO anhand folgender einfachen Gleichung: $R _ ISO = \frac{\left(Uq1-Ia1⋅Ra\right) + \left(Uq1-Ib1⋅Rb\right) - \left(Uq2-Ia2⋅Ra\right) - \left(Uq2-Ib2⋅Ra\right)}{n ⋅ \left(\left(Ia1-Ia2\right)+\left(Ib1-Ib2\right)\right)}$ wobei sind:
- Uq1: der erste Spannungswert der ersten Gleichspannung;
- Uq2: der zweite Spannungswert der zweiten Gleichspannung;
- Ia1, Ib1: die jeweiligen ersten Strommesswerte der Ströme, die unter Einwirkung der ersten Gleichspannung jeweils durch den ersten und den zweiten Strompfad fließen;
- Ia2, Ib2: die jeweiligen zweiten Strommesswert der Ströme, die unter Einwirkung der zweiten Gleichspannung jeweils durch den ersten und den zweiten Strompfad fließen;
- n: ein Zahlenkoeffizient ist, der vorzugsweise 2 ist;
- Ra und Rb: die jeweiligen Widerstände in dem ersten und dem zweiten Strompfad, durch die die jeweiligen Ströme unter Einwirkung der ersten und der zweiten Gleichspannung fließen.

Die Strommesswerte Ia1, Ia2, Ib1, Ib2 werden entweder direkt von der ersten bzw. der zweiten Strommesseinheiten gemessen oder aus den Strommesswerten der ersten und der dritten Strommesseinheiten oder aus den Strommesswerten der zweiten und der dritten Strommesseinheit anhand folgender Gleichungen berechnet: $Ic 1 = Ia 1 + Ib 1$ $Ic 2 = Ia 2 + Ib 2$ wobei
- Ic1: ein erster Strommesswert eines unter Einwirkung der ersten Gleichspannung durch den dritten Strompfad fließenden Stromes;
- Ic2: ein zweiter Strommesswert eines unter Einwirkung der zweiten Gleichspannung durch den dritten Strompfad fließenden Stromes.

Der Isolationswiderstand wird somit als Quotient aus der Differenz zwischen der ersten und der zweiten angelegten Gleichspannung korrigiert um die jeweiligen an den Widerständen abfallenden Spannungen, und der Differenz der beiden Stromwerte berechnet, die jeweils unter Einwirkung der ersten und der zweiten Gleichspannung durch den ersten bzw. den zweiten Strompfad fließen.

Gemäß noch einer weiteren bevorzugten Ausgestaltung der Vorrichtung beträgt der erste Spannungswert der ersten Gleichspannung 50 bis 60 Volt. Vorzugsweise beträgt der zweite Spannungswert der zweiten Gleichspannung -60 bis -50 Volt.

Dabei stellen die oberen Grenzwerte 60 bzw. -60 Volt die Obergrenze der generierbaren Gleisspannungen dar, die für Menschen bzw. Fahrzeuginsassen noch nicht lebensgefährlich sind.

Die unteren Grenzwerte 50 bzw. -50 Volt ermöglichen einen Spannungshub von mindestens 100 Volt zwischen den beiden Gleisspannungen, was bei den Strommesswerten des ersten, des zweiten und des dritten Stromes entsprechend große Werteunterschiede mit sich bringt. Die großen Werteunterschiede bei den Strommesswerten ermöglichen wiederum eine genaue Ermittlung des Isolationswiderstands. Zudem sind die hohen Spannungswerte robust gegenüber Spannungsschwankungen in den Strompfaden bzw. im Bordnetz.

Gemäß einem weiteren Aspekt der Erfindung wird ein Bordnetz für ein Fahrzeug, insb. ein Hybrid-/Elektrofahrzeug, bereitgestellt, wobei das Bordnetz eine zuvor beschriebene Vorrichtung zur Überwachung der elektrischen Isolation bei dem Bordnetz bzw. zwischen einem Hochvoltbordnetzzweig des Bordnetzes und dem Rest des Bordnetzes bzw. der Fahrzeugkarosserie aufweist.

Gemäß noch einem weiteren Aspekt der Erfindung wird ein Fahrzeug, insb. ein Hybrid-/Elektrofahrzeug, mit einem Bordnetz bereitgestellt, wobei das Bordnetz eine zuvor beschriebene Vorrichtung zur Überwachung der elektrischen Isolation bei dem Bordnetz bzw. zwischen einem Hochvoltbordnetzzweig des Bordnetzes und dem Rest des Bordnetzes bzw. der Fahrzeugkarosserie aufweist.

Gemäß noch einem weiteren Aspekt der Erfindung wird ein Verfahren zur Überwachung einer elektrischen Isolation bei einem Bordnetz eines Fahrzeugs, insb. eines Hybrid-/Elektrofahrzeugs, bereitgestellt. Dabei weist das Verfahren folgende Verfahrensschritte auf:
- Schalten bzw. Anschließen einer Spannungsquelle elektrisch zwischen elektrischer Masse und einem Stromanschlusspunkt, über den eine positive Stromversorgungsleitung des Bordnetzes und eine negative Stromversorgungsleitung des Bordnetzes miteinander elektrisch verbunden bzw. verbindbar sind;
- erstes Generieren einer ersten Gleichspannung mit einem ersten Spannungswert mittels der Spannungsquelle;
- erstes Messen jeweils eines ersten Strommesswertes eines ersten und eines zweiten Stromes, wobei der erste und der zweite Strom unter Einwirkung der ersten Gleichspannung jeweils durch einen der folgenden drei Strompfade fließen:
   - eines ersten Strompfades zwischen der positiven Stromversorgungsleitung und dem Stromanschlusspunkt,
   - eines zweiten Strompfades zwischen der negativen Stromversorgungsleitung und dem Stromanschlusspunkt,
   - eines dritten Strompfades zwischen dem Stromanschlusspunkt und der Spannungsquelle;
- zweites Generieren einer zweiten Gleichspannung mit einem zweiten Spannungswert mittels der Spannungsquelle;
- zweites Messen jeweils eines zweiten Strommesswertes des ersten und des zweiten, jeweils unter Einwirkung der zweiten Gleichspannung durch den jeweiligen Strompfad fließenden Stromes;
- Ermitteln eines Isolationswiderstands zwischen dem Bordnetz und elektrischer Masse aus dem ersten und dem zweiten Spannungswert sowie den ersten und den zweiten Strommesswerten.

Demnach wird eine Spannungsquelle zwischen elektrischer Masse und einem Stromanschlusspunkt des Bordnetzes geschaltet bzw. elektrisch angeschlossen, über den eine positive Stromversorgungsleitung des Bordnetzes und eine negative Stromversorgungsleitung des Bordnetzes miteinander elektrisch verbunden bzw. verbindbar sind. Als elektrische Masse dient hier bspw. die Fahrzeugkarosserie oder ein elektrischer Masseanschluss des Bordnetzes.

Zur Überwachung der elektrischen Isolation bei dem Bordnetz wird mit der Gleichspannungsquelle eine erste Gleichspannung mit einem ersten Spannungswert für eine bestimmte erste Zeitdauer generiert.

Durch die erste Gleichspannung entsteht jeweils ein Stromfluss von dem dritten Strompfad zu dem ersten Strompfad bzw. von dem dritten Strompfad zu dem zweiten Strompfad. Diese Stromflüsse überlappen sich mit einem Stromfluss, der von der positiven Stromversorgungsleitung über den ersten und den zweiten Strompfad zu der negativen Stromversorgungsleitung fließt.

Diese überlappenden Stromflüsse führen zur Veränderungen bei den Strömen, die durch den ersten und den zweiten Strompfad fließen.

Diese Stromveränderungen werden gemessen und als erste Strommessewerte zur Ermittlung des Isolationswiderstands aufgehoben.

Um einen vorgegeben Zeitintervall mittelbar oder unmittelbar nach dem Messen der ersten Strommesswerte wird mit der Gleichspannungsquelle eine zweite Gleichspannung mit einem zweiten Spannungswert für eine bestimmte zweite Zeitdauer generiert.

Entsprechend werden Ströme bzw. Veränderungen der Ströme, die unter Einwirkung der zweiten Gleichspannung durch die jeweiligen Strompfade fließenden, in dieser zweiten Zeitdauer gemessen, in der die zweite Gleichspannung generiert wird. Die zweiten Strommesswerte werden dann mit den zuvor gemessenen ersten Strommesswerten zur Ermittlung des Isolationswiderstandes herangezogen.

Aus diesen ersten und zweiten Strommesswerten und den beiden Spannungswerten wird dann ein Isolationswiderstand zwischen dem Bordnetz und der elektrischen Masse bzw. zwischen einem Hochvoltbordnetzzweig des Bordnetzes und dem Rest des Bordnetzes bzw. der elektrischen Masse ermittelt.

Der ermittelte Isolationswiderstandswert wird im Anschluss mit einem vorgegebenen Referenzwiderstandswert verglichen. Beim Unterschreiten des Referenzwiderstandswertes durch den ermittelten Isolationswiderstandswert wird von einem elektrischen Leck zwischen dem Bordnetz und der elektrischen Masse bzw. zwischen dem Hochvoltbordnetzzweig und dem Rest des Bordnetzes oder der elektrischen Masse ausgegangen.

Gemäß einer bevorzugten Ausgestaltung des Verfahrens wird der Isolationswiderstand als Quotient aus der Differenz zwischen dem ersten Spannungswert der ersten Gleichspannung und dem zweiten Spannungswert der zweiten Gleichspannung korrigiert um die jeweiligen an jeweiligen Widerständen der jeweiligen Strompfade abfallenden Spannungswerten, und der Differenz zwischen den ersten und den zweiten Stromwerten der Ströme berechnet, die jeweils unter Einwirkung der ersten und der zweiten Gleichspannung durch den ersten bzw. den zweiten Strompfad fließen.

Gemäß einer bevorzugten Ausgestaltung des Verfahrens wird der Isolationswiderstand anhand der oben genannten Gleichung ermittelt: $R _ ISO = \frac{\left(Uq1-Ia1⋅Ra\right) + \left(Uq1-Ib1⋅Rb\right) - \left(Uq2-Ia2⋅Ra\right) - \left(Uq2-Ib2⋅Ra\right)}{n ⋅ \left(\left(Ia1-Ia2\right)+\left(Ib1-Ib2\right)\right)}$

Gemäß einer weiteren bevorzugten Ausgestaltung des Verfahrens werden beim Messen der ersten Strommesswerte ein erster Betriebsspannungswert der Betriebsspannung des Bordnetzes und beim Messen der zweiten Strommesswerte ein zweiter Betriebsspannungswert der Betriebsspannung gemessen. Der erste und der zweite Betriebsspannungswert werden anschließend miteinander verglichen.

Weichen der erste und der zweite Betriebsspannungswert um mehr als einen vorgegebenen Grenzwert voneinander ab, so werden die ersten Strommesswerte verworfen und mittels der Spannungsquelle eine dritte Gleichspannung mit einem dritten Spannungswert generiert. Ferner werden jeweils ein dritter Strommesswert des ersten und des zweiten, jeweils unter Einwirkung der dritten Gleichspannung durch den jeweiligen Strompfad fließenden Stromes sowie eine dritter Betriebsspannungswert der Betriebsspannung gemessen. Der zweite und der dritte Betriebsspannungswert werden anschließend miteinander verglichen. Weichen der zweite und der dritte Betriebsspannungswert voneinander nicht oder um weniger als den Grenzwert ab, so wird der Isolationswiderstand aus dem zweiten und dem dritten Spannungswert sowie den zweiten und den dritten Strommesswerten ermittelt.

Dabei werden die Verfahrensschritte "Generieren" und "Messen" solange wiederholt, bis die Betriebsspannung zwischen zwei aufeinanderfolgenden Messschritten konstant bleibt.

Gemäß einer alternativen Ausgestaltung des Verfahrens werden die ersten Strommesswerte bei einer Abweichung zwischen dem ersten und dem zweiten Betriebsspannungswert um mehr als den Grenzwert nicht weggeworfen. Dagegen wird der Isolationswiderstand weiterhin aus dem ersten und dem zweiten Spannungswert sowie den ersten und den zweiten Strommesswerten ermittelt und um einen Korrekturfaktor korrigiert. Dabei wird der Korrekturfaktor abhängig von der Abweichung zwischen dem ersten und dem zweiten Betriebsspannungswert ermittelt. Vorzugsweise wird der Korrekturfaktor abhängig von der Abweichung aus einer Korrekturfaktor-Tabelle (so genannte Look-Up-Tabelle) abgelesen, in der verschiedene Korrekturfaktoren für verschiedene Abweichungen der Betriebsspannungswerte im Vorfeld ermittelt und ablesbar gespeichert sind.

Gemäß einer weiteren bevorzugten Ausgestaltung des Verfahrens wird neben den ersten Strommesswerten des ersten und des zweiten Stromes zeitgleich noch ein erster Strommesswert eines dritten Stromes gemessen, wobei der erste, der zweite und der dritte Strom unter Einwirkung der ersten Gleichspannung jeweils durch einen der drei Strompfade fließen. Außerdem wird neben den zweiten Strommesswerten des ersten und des zweiten Stromes zeitgleich noch ein zweiter Strommesswert des dritten Stromes gemessen, wobei der erste, der zweite und der dritte Strom unter Einwirkung der zweiten Gleichspannung jeweils durch einen der drei Strompfade fließen. Der erste und der zweite Strommesswert des dritten Stromes werden zum Überprüfen der Genauigkeit des ermittelten Isolationswiderstands herangezogen.

Dabei können die jeweiligen ersten bzw. die jeweiligen zweiten Strommesswerte der drei Ströme miteinander verglichen werden. Hierzu wird eine Knotengleichung nach dem "kirchhoffschen" Regeln für den Stromanschlusspunkt erstellt und überprüft, ob die Summe der jeweiligen ersten bzw. der jeweiligen zweiten Strommesswerte 0 (null) ist. Bei einer Abweichung der Summe von 0 werden die jeweiligen ersten bzw. zweiten Stromesswerte verworfen oder um entsprechende Faktoren korrigiert.

Alternativ können die beiden Strommesswerte des dritten Stromes zur Ermittlung des Isolationswiderstands herangezogen werden. In diesem Fall wird der Isolationswiderstand jeweils anhand der jeweiligen beiden Strommesswerte des ersten und des zweiten Stromes, anhand der jeweiligen beiden Strommesswerte des ersten und des dritten Stromes, sowie anhand der jeweiligen beiden Strommesswerte des zweiten und des dritten Stromes dreimal voneinander unabhängig berechnet. Der Isolationswiderstand wird dann als Mittelwert der drei berechneten Isolationswiderstandswerte bestimmt. Alternativ werden ein oder andere Isolationswiderstandwerte, die nicht plausibel erscheinen, verworfen und der Isolationswiderstand wird dann aus den übrig gebliebenen plausibel erscheinenden Isolationswiderstandwerten bestimmt.

Gemäß noch einer weiteren bevorzugten Ausgestaltung des Verfahrens finden die zuvor genannten Verfahrensschritte des ersten Generierens, des ersten Messens, des zweiten Generierens, des zweiten Messens und des Ermittelns während des Fahrbetriebs des Fahrzeugs statt. Damit kann die elektrische Isolation bei dem Bordnetz auch in der Zeit ermittelt werden, in der in dem Bordnetz Betriebsspannung vorliegt und Bordnetzströme fließen.

Werden die Gleichspannungen während des Fahrbetriebs des Fahrzeugs generiert und die genannten Ströme während des Fahrbetriebs des Fahrzeugs gemessen, so wird die Betriebsspannung am Hochvoltbordnetzzweig mit gemessen.

Bei der obigen Gleichung wird vorausgesetzt, dass sich die Betriebsspannung im Bordnetz bzw. im Hochvoltbordnetzzweig nicht ändert.

Bleibt die Betriebsspannung über die gesamte Dauer des Verfahrens konstant, so wird der Isolationswiderstand anhand der obigen Gleichung ermittelt. Der so gewonnene Isolationswiderstandswert wird dann mit einem vorgegebenen Referenzwiderstandswert verglichen.

Ändert sich aber die Betriebsspannung in der Zeit zwischen der ersten und der zweiten Messung, so werden die ersten Strommesswerte, wie zuvor in einer bevorzugten Ausgestaltung vorgeschlagen, verworfen und eine dritte Gleichspannung generiert und weitere Strommesswerte gemessen. Die so gemessenen dritten Strommesswerte und der dritte Spannungswert der dritten Gleichspannung werden dann anstelle der ersten Strommesswerte und des ersten Spannungswertes zur Ermittlung des Isolationswiderstandes herangezogen.

Dabei werden die Verfahrensschritte "Generieren" und "Messen" solange wiederholt, bis die Betriebsspannung zwischen zwei aufeinanderfolgenden Messschritten konstant bleibt.

Alternativ kann die Veränderung bei der Betriebsspannung während der Verfahrensschritte "Generieren" und "Messen" bei der Ermittlung des Isolationswiderstands berücksichtigt werden. Wie oben bereits erwähnt, wird der anhand der obigen Gleichung ermittelte Isolationswiderstand in diesem Fall abhängig von der Veränderung der Betriebsspannung bzw. der Abweichung bei den gemessenen Betriebsspannungswerten um einen entsprechenden Korrekturfaktor korrigiert. Hierzu werden entsprechende Korrekturfaktoren bei verschiedenen Anfangs- und Veränderungswerten der Betriebsspannung im Vorfeld ermittelt und in der Korrekturfaktor-Tabelle gespeichert. Zum Korrigieren des berechneten Isolationswiderstands kann ein Korrekturfaktor abhängig von der Abweichung zwischen den gemessenen Betriebsspannungswerten von der Tabelle abgelesen werden. Der berechnete Isolationswiderstand wird dann um diesen Korrekturfaktor korrigiert. Der so gewonnene korrigierte Isolationswiderstandswert wird dann als aktueller Isolationswiderstandswert des Hochvoltbordnetzzweigs mit dem Referenzwiderstandswert verglichen.

Die oben genannten fünf Verfahrensschritte vom "ersten Generieren" bis zum "Ermitteln" können aber auch in der Zeit zyklisch stattfinden, in der sich das Fahrzeug nicht im Fahrbetrieb befindet und die Betriebsspannung im Hochvoltbordnetzzweig 0 Volt beträgt.

Vorteilhafte Ausgestaltungen der oben dargestellten Vorrichtung sind, soweit im Übrigen auf das oben genannte Bordnetz oder Fahrzeug bzw. auf das oben beschriebene Verfahren übertragbar, auch als vorteilhafte Ausgestaltungen des Bordnetzes, des Fahrzeugs bzw. des Verfahrens anzusehen. Analog sind vorteilhafte Ausgestaltungen des oben beschriebenen Verfahrens, soweit im Übrigen auf die oben beschriebene Vorrichtung, das Bordnetz oder das Fahrzeug übertragbar, auch als vorteilhafte Ausgestaltungen der Vorrichtung, des Bordnetzes oder des Fahrzeugs anzusehen.

Im Folgenden sollen nun beispielhafte Ausführungsformen der vorliegenden Erfindung Bezug nehmend auf die beiliegenden Zeichnungen näher erläutert werden. Dabei zeigen:
- Figur 1: in einer schematischen Darstellung ein Bordnetz eines Elektrofahrzeugs mit einer Vorrichtung gemäß einer Ausführungsform der Erfindung;
- Figur 2: in einem schematischen Diagramm ein Verfahren gemäß einer Ausführungsform der Erfindung.

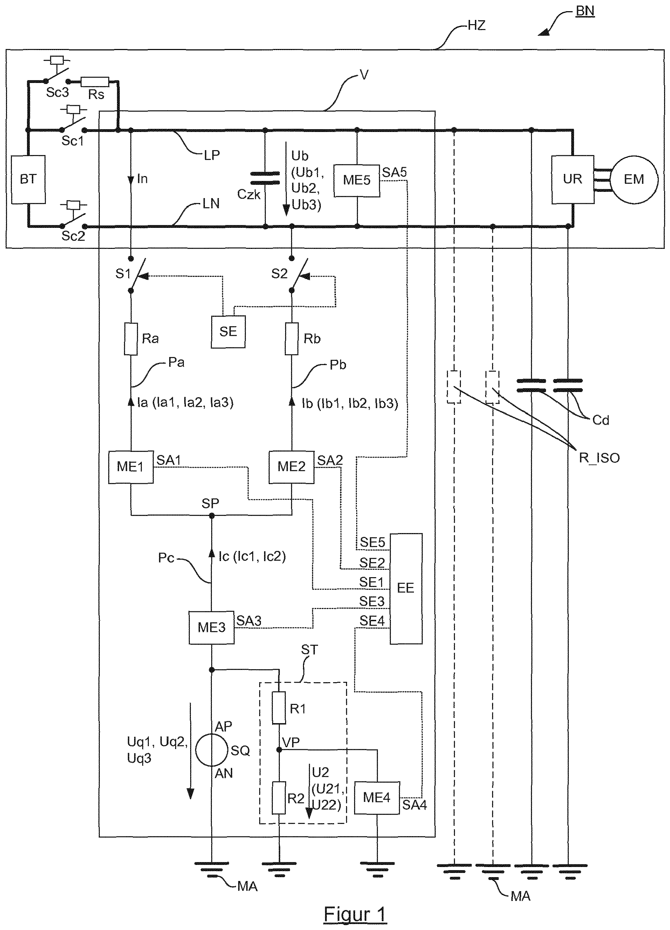

Es sei zunächst auf Figur 1 verwiesen, in der ein Bordnetz BN eines in der Figur nicht dargestellten Elektrofahrzeugs mit einer Vorrichtung V zur Überwachung einer elektrischen Isolation bei dem Bordnetz schematisch dargestellt ist.

Das Bordnetz BN umfasst einen Hochvoltbordnetzzweig HZ, in dem eine Betriebsspannung Ub von ca. 500 Volt, herrscht. Dieser Hochvoltbordnetzzweig HZ dient zum Bereitstellen von elektrischem Strom für eine elektrische Maschine EM in dem Hochvoltbordnetzzweig HZ, die zum Antrieb des Elektrofahrzeugs dient.

In diesem Hochvoltbordnetzzweig HZ weist das Bordnetz BN eine Traktionsbatterie BT als Energie- bzw. Stromquelle auf, die den zum Betrieb der elektrischen Maschine EM bzw. zum Antrieb des Elektrofahrzeugs erforderlichen Strom bereitstellt.

Über jeweils ein steuerbares Schütz Sc1, Sc2 ist die Traktionsbatterie BT mit jeweils einer positiven und einer negativen Stromversorgungsleitung LP, LN des Hochvoltbordnetzzweigs HZ elektrisch verbunden. Zusätzlich zu dem ersten Schütz Sc1 ist die Traktionsbatterie BT über ein drittes steuerbares Schütz Sc3 und einen Schutzwiderstand Rs mit der positiven Stromversorgungsleitung LP elektrisch verbunden, wobei das dritte Schütz Sc3 und der Schutzwiderstand Rs zueinander in Serie und zu dem ersten Schütz Sc1 parallel zwischen der Traktionsbatterie BT und der positiven Stromversorgungsleitung LP elektrisch angeschlossen sind.

In dem Hochvoltbordnetzzweig HZ weist das Bordnetz BN ferner einen Umrichter UR auf, der den von der Traktionsbatterie BT bereitgestellten Strom in die Phasenströme umwandelt und die elektrische Maschine EM mit diesen Phasenströmen speist.

Die positive Stromversorgungsleitung LP und die negative Stromversorgungsleitung LN verbinden dabei die Traktionsbatterie BT mit dem Umrichter UR, durch die der Strom von der Traktionsbatterie BT zu dem Umrichter UR fließt.

Zwischen der positiven Stromversorgungsleitung LP und der negativen Stromversorgungsleitung LN weist das Hochvoltbordnetzzweig HZ einen Zwischenkreiskondensator Czk auf, der Spannungsschwankungen bei der Betriebsspannung Ub des Hochvoltbordnetzzweigs HZ kompensiert und die Betriebsspannung Ub auf erforderlichen Spannungswert aufrechthält.

Zwischen der positiven Stromversorgungsleitung LP und der negativen Stromversorgungsleitung LN ist ferner eine Spannungsmesseinheit ME5 vorgesehen, die zur Überwachung der Spannungsschwankungen im Hochvoltbordnetzzweig HZ regelmäßig die Betriebsspannung Ub misst.

Der Hochvoltbordnetzzweig HZ weist zwischen der positiven Stromversorgungsleitung LP und elektrischer Masse MA bzw. zwischen der negativen Stromversorgungsleitung LN und der elektrischen Masse MA jeweils eine Ableitkapazität Cd auf.

Das Bordnetz BN umfasst ferner einen in der Figur nicht dargestellten Niedervoltbordnetzzweig, in dem je nach Ausführung des Elektrofahrzeugs eine Betriebsspannung von bspw. 12 Volt herrscht. In diesem Niedervoltbordnetzzweig sind Stromverbraucher elektrisch angeschlossen, die bei der Betriebsspannung 12 Volt funktionieren. Diese Stromverbraucher sind bspw. Fahrzeugbeleuchtung, Navigationsgerät, elektrische Scheibenheizung oder Elektrische Klimakompressor.

Die Betriebsspannung Ub in dem Hochvoltbordnetzzweig HZ ist mit 500 Volt für Fahrzeuginsassen lebensgefährlich. Damit der Strom in dem Hochvoltbordnetzzweig HZ mit der hohen Betriebsspannung Ub nicht über den Niederspanungsbordnetzzweig bzw. über elektrische Masse MA am Bordnetz BN oder Fahrzeugkarosserie unkontrolliert entlädt und die Gesundheit der Fahrzeuginsassen gefährdet, sind der Hochvoltbordnetzzweig HZ bzw. die beiden Stromversorgungsleitungen LP, LN von dem Rest des Bordnetzes BN und somit von dem Niederspanungsbordnetzzweig bzw. der elektrischen Masse MA galvanisch getrennt und elektrisch isoliert.

Die elektrische Isolation zwischen dem Hochvoltbordnetzzweig HZ und dem Rest des Bordnetzes BN und somit der elektrischen Masse MA ist in der Figur mit fiktivem Isolationswiderstand R_ISO schematisch dargestellt.

Damit kein Strom von dem Hochvoltbordnetzzweig HZ zu dem Niederspanungsbordnetzzweig bzw. zu der elektrischen Masse MA fließen und Stromschlag bei Menschen verursachen kann, muss der Isolationswiderstand R_ISO ausreichend hoch sein.

Treten Defekte oder Fehler im Bordnetz BN, so kann es vorkommen, dass die galvanische Trennung zwischen dem Hochvoltbordnetzzweig HZ und dem Rest des Bordnetzes BN bzw. der elektrischen Masse MA unterbrochen wird, was zu Schäden am Elektrofahrzeug und bei Fahrzeuginsassen führen kann.

Zur Erhöhung der Sicherheit bei dem Elektrofahrzeug muss die elektrische Isolation bzw. ein Isolationswiderstand zwischen dem Hochvoltbordnetzzweig HZ und dem Rest des Bordnetzes BN bzw. der elektrischen Masse MA kontinuierlich überwacht werden. Beim Unterschreiten eines vorbestimmten Referenzwiderstandswertes durch den Isolationswiderstandswert muss die Traktionsbatterie BT durch gesteuertes Öffnen der alle drei Schütze Sc1, Sc2, Sc3 von dem Hochvoltbordnetzzweig HZ elektrisch getrennt werden und der Zwischenkreiskondensator Czk bis auf eine Ladespannung unter 60 Volt entladen werden.

Hierzu umfasst das Bordnetz BN eine Vorrichtung V zur Überwachung der elektrischen Isolation in dem Bordnetz BN bzw. zwischen dem Hochvoltbordnetzzweig HZ und dem Rest des Bordnetzes BN bzw. der elektrischen Masse MA.

Die Vorrichtung V weist einen Stromanschlusspunkt SP auf, über den die positive und die negative Stromversorgungsleitung LP, LN des Hochvoltbordnetzzweigs HZ miteinander elektrisch verbunden bzw. verbindbar sind.

Zwischen dem Stromanschlusspunkt SP und der positiven Stromversorgungsleitung LP weist die Vorrichtung V einen ersten Strompfad Pa auf, in dem ein erster steuerbarer Schalter S1, ein erster Ankoppelwiderstand Ra und eine erste Strommesseinheit ME1 in Reihe geschaltet sind.

Analog weist die Vorrichtung V zwischen dem Stromanschlusspunkt SP und der negativen Stromversorgungsleitung LN einen zweiten Strompfad Pb auf, in dem ein zweiter steuerbarer Schalter S2, ein zweiter Ankoppelwiderstand Rb und eine zweite Strommesseinheit ME2 in Reihe geschaltet sind.

Zwischen dem Stromanschlusspunkt SP und der elektrischen Masse MA weist die Vorrichtung V eine Spannungsquelle SQ auf, die als Gleichspannungswandler mit einem ein-/ausschaltbaren Inverter ausgebildet ist. Über einen positiven Stromanschluss AP ist die Spannungsquelle SQ mit dem Stromanschlusspunkt SP elektrisch verbunden. Über einen negativen Stromanschluss AN ist die Spannungsquelle SQ mit der elektrischen Masse MA elektrisch verbunden.

Zwischen dem Stromanschlusspunkt SP und dem positiven Stromanschluss AP der Spannungsquelle SQ hat sich somit ein dritter Strompfad Pc ausgebildet, in dem eine dritte Strommesseinheit ME3 der Vorrichtung V elektrisch angeschlossen ist.

Zwischen dem positiven Stromanschluss AP der Spannungsquelle SQ und der elektrischen Masse MA weist die Vorrichtung V einen Spannungsteiler ST auf, der parallel zu der Spannungsquelle SQ geschaltet ist. Der Spannungsteiler ST umfasst zwei in Reihe geschaltete Widerstände R1, R2. Zwischen einem elektrischen Verbindungspunkt VP dieser beiden Widerstände R1, R2 und der elektrischen Masse MA weist die Vorrichtung V eine Spannungsmesseinheit ME4 auf.

Die Vorrichtung V umfasst ferner eine Steuereinheit SE zum Schließen bzw. Öffnen der beiden Schalter S1, S2.

Die Vorrichtung V umfasst außerdem eine Ermittlungseinheit EE zum Ermitteln des fiktiven Isolationswiderstands R_ISO. Die Ermittlungseinheit EE umfasst einen ersten, einen zweiten, einen dritten, einen vierten und einen fünften Signaleingang SE1, SE2, SE3, SE4 und SE5. Über den ersten Signaleingang SE1 ist die Ermittlungseinheit EE mit einem Signalausgang SA1 der ersten Strommesseinheit ME1, über den zweiten Signaleingang SE2 mit einem Signalausgang SA2 der zweiten Strommesseinheit ME2, über den dritten Signaleingang SE3 mit einem Signalausgang SA3 der dritten Strommesseinheit ME3 und über den vierten Signaleingang SE4 mit einem Signalausgang SA4 der Spannungsmesseinheit ME4 elektrisch verbunden. Über den fünften Signaleingang SE5 ist die Ermittlungseinheit EE mit einem Signalausgang SA5 der Spannungsmesseinheit ME5 elektrisch verbunden.

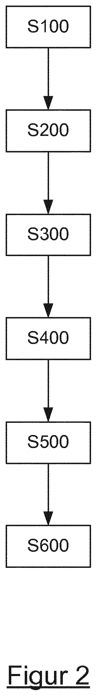

Die Funktionsweise der Vorrichtung V, insb. der Ermittlungseinheit EE wird nachfolgend anhand Figur 2 in Verbindung mit der Beschreibung des Verfahrens zur Überwachung der elektrischen Isolation bei dem Bordnetz BN bzw. bei dem Hochvoltbordnetzzweig HZ des Bordnetzes BN näher beschrieben.

Zur Überwachung der elektrischen Isolation bei dem Bordnetz BN wird der fiktive Isolationswiderstand R_ISO während des Betriebs des Elektrofahrzeugs kontinuierlich ermittelt.

Hierzu schließt die Steuereinheit SE gemäß einem Verfahrensschritt S100 die beiden Schalter S1, S2 und schließt somit die Vorrichtung V samt der Spannungsquelle SQ an den Hochvoltbordnetzzweig HZ an und stellt elektrische Verbindungen in dem ersten und dem zweiten Strompfad Pa, Pb her. Dadurch bildet sich ein Stromkreis von der positiven Stromversorgungsleitung LP über den ersten und den zweiten Strompfad Pa, Pb zur negativen Stromversorgungsleitung LN, durch den ein Netzstrom In von der positiven Stromversorgungsleitung LP zur negativen Stromversorgungsleitung LN fließt.

Die Spannungsquelle SQ generiert gemäß einem Verfahrensschritt S200 eine erste Gleichspannung mit einem ersten vorgegebenen Spannungswert Uq1 von 60 Volt für eine vorgegebene erste Zeitdauer. Dabei wandelt die Spannungsquelle SQ die 12 Volt Betriebsspannung vom Niedervoltbordnetzzweig auf 60 Volt um.

Diese erste Gleichspannung erzeugt Gleichströme Ic, Ia, Ib, die von dem dritten Strompfad Pc zu dem ersten und dem zweiten Strompfad Pa, Pb fließen. Diese Gleichströme Ia, Ib, die durch den ersten und den zweiten Strompfad Pa, Pb fließen, überlappen sich somit mit dem durch den ersten und den zweiten Strompfad Pa, Pb fließenden Netzstrom In und führen bei dem Netzstrom In zu Stromveränderungen. Diese Stromveränderungen werden von der ersten und der zweiten Strommesseinheit ME1, ME2 gemäß einem weiteren Verfahrensschritt S300 gemessen und als jeweilige erste Strommesswerte Ia1, Ib1 über die jeweiligen Signalausgänge SA1, SA2 an die Ermittlungseinheit EE weitergeleitet. Die dritte Strommesseinheit ME3 misst ebenfalls den Gleichstrom Ic, der unter Einwirklung der ersten Gleichspannung durch den dritten Strompfad Pc fließt, und leitet einen ersten Strommesswert Ic1 des Gleichstromes über den Signalausgang SA3 an die Ermittlungseinheit EE weiter.

Dabei messen die drei Strommesseinheiten ME1, ME2, ME3 um einen vorgegebenen Zeitabstand von dem Startzeitpunkt, zu dem die Spanungsquelle SQ anfängt, die erste Gleichspannung generiert, zeitlich versetzt die entsprechenden Ströme Ia, Ib und Ic. Dieser vorgegebene Zeitabstand entspricht der Dauer, die der Zwischenkreiskondensator Czk und die Ableitkapazitäten Cd nach Anlegen der ersten Gleichspannung an dem Hochvoltbordnetzzweig HZ zum Abklingen brauchen.

Zeitgleich misst die Spannungsmesseinheit ME4 die an dem Widerstand R2 des Spannungsteiles ST abfallende Spannung U2 und gibt über den Signalausgang SA4 einen ersten Spannungsmesswert U21 an die Ermittlungseinheit EE ab.

Im Fahrbetrieb des Elektrofahrzeugs speist die Traktionsbatterie BT über die beiden Stromversorgungsleitungen LP, LN den Umrichter UR bzw. die elektrische Maschine EM mit Strom. Aufgrund der Lastschwankungen im Hochvoltbordnetzzweig HZ schwankt die Betriebsspannung Ub. Die Spannungsschwankungen bei der Betriebsspannung Ub beeinflussen das Ermittlungsergebnis des Isolationswiderstands R_ISO. Um den Isolationswiderstand R_ISO zuverlässig ermitteln zu können, werden die Spannungsschwankungen bei der Betriebsspannung Ub bei der Ermittlung berücksichtigt.

Hierzu erhält die Ermittlungseinheit EE über den fünften Signaleingang SE5 von der im Hochvoltbordnetzzweig HZ befindlichen Spannungsmesseinheit ME5 einen ersten Betriebsspannungswert Ub1, den die Spannungsmesseinheit ME5 zeitgleich zu der Messung der ersten Strommesswerte Ia1, Ib1, Ic1 gemessen hat.

Nach Ablauf der ersten Zeitdauer und einem weiteren vorgegebenen Zeitintervall, der zum Abklingen des Zwischenkreiskondensators Czk und der Ableitkapazitäten Cd erforderlich ist, generiert die Spannungsquelle SQ gemäß einem weiteren Verfahrensschritt S400 eine zweite Gleichspannung mit einem zweiten vorgegebenen Spannungswert Uq2 von -60 Volt für eine vorgegebene zweite Zeitdauer. Dabei wandelt die Spannungsquelle SQ die 12 Volt Betriebsspannung vom Niedervoltbordnetzzweig auf 60 Volt um und invertiert diese.

Gemäß einem weiteren Verfahrensschritt S500 und analog zu dem Verfahrensschritt S300 und messen die drei Strommesseinheiten ME1, ME2, ME3 während der zweiten Zeitdauer und zu dem Startzeitpunkt, zu dem die Spanungsquelle SQ anfängt, die zweite Gleichspannung generiert, um einen vorgegebenen Zeitabstand zeitlich versetzt die entsprechenden Ströme Ia, Ib und Ic, die unter Einwirkung der zweiten Gleichspannung durch die jeweiligen Strompfade Pa, Pb und Pc fließen und somit den jeweiligen Stromveränderungen entsprechen, die durch die zweite Gleichspannung hervorgerufen sind. Anschließend leiten die drei Strommesseinheiten ME1, ME2, ME3 jeweilige zweite Strommesswerte Ia2, Ib2, Ic2 an die Ermittlungseinheit EE weiter.

Zeitgleich misst die Spannungsmesseinheit ME4 die an dem Widerstand R2 des Spannungsteiles ST abfallende Spannung U2 und gibt einen zweiten Spannungsmesswert U22 an die Ermittlungseinheit EE ab.

Ebenfalls zeitgleich misst die Spannungsmesseinheit ME5 die Betriebsspannung Ub im Hochvoltbordnetzzweig HZ und leitet als Messwert einen zweiten Betriebsspannungswert Ub2 an die Ermittlungseinheit EE weiter.

Die Ermittlungseinheit EE vergleicht gemäß einem weiteren Verfahrensschritt S600 die beiden Betriebsspannungswerte Ub1, Ub2 miteinander.

Weichen die beiden Betriebsspannungswerte Ub1, Ub2 voneinander ab und übersteigt die Abweichung zwischen den beiden Betriebsspannungswerten Ub1, Ub2 einen vorgegebenen Grenzwert, so werden die ersten Strommesswerte Ia1, Ib1 verworfen und die Verfahrensschritte S200 und S300 wiederholt. Hierzu wird die erste Gleichspannung mit dem Spannungswert Uq1 von 60 Volt erneut generiert und die Ströme Ia, Ib, Ic sowie die Spannungen U2, Ub werden erneut gemessen.

Der so gewonnene dritte Betriebsspannungswert Ub3 wird dann mit dem zuletzt gemessenen zweiten Betriebsspannungswert Ub2 verglichen. Übersteigt die Abweichung zwischen dem zweiten und dem dritten Betriebsspannungswert Ub2, Ub3 weiterhin den Grenzwert, so werden auch die zweiten Strommesswerte Ia2, Ib2 verworfen und die Verfahrensschritte S400 und S500 wiederholt. Hierzu wird die zweite Gleichspannung mit dem Spannungswert Uq2 von -60 Volt erneut generiert und die Ströme Ia, Ib, Ic sowie die Spannungen U2, Ub werden erneut gemessen.

Die Verfahrensschritte S200 und S300 bzw. S400 und S500 werden solange wiederholt, bis die Abweichung zwischen zwei aufeinander folgend gemessenen Betriebsspannungswerten kleiner als der Grenzwert ist.

Sind die beiden Betriebsspannungswerte Ub1, Ub2 gleich oder die Abweichung zwischen den beiden Betriebsspannungswerte Ub1, Ub2 kleiner als der Grenzwert, so berechnet die Ermittlungseinheit EE aus dem ersten und dem zweiten Spannungsmesswert U21, U22 anhand folgender zwei Gleichungen den ersten Spannungswert Uq1 der ersten Gleichspannung und den zweiten Spannungswert Uq2 der zweiten Gleichspannung, die die Spannungsquelle SQ tatsächlich generiert hat: $Uq 1 = \frac{R 1 + R 2}{R 2} ⋅ U 21$ $Uq 2 = \frac{R 1 + R 2}{R 2} ⋅ U 22$

Durch die Messung der beiden Spannungsmesswerte U21, U22 und die anschließende Berechnung der beiden Spannungswerte Uq1, Uq2 der tatsächlich generierten Gleichspannungen wird eine mögliche Ermittlungsfehler des Isolationswiderstands durch Abweichung bei der Spannungsquelle SQ vermieden und somit die Genauigkeit bei dem ermittelten Isolationswiderstand R_ISO erhöht. Nachdem die Ermittlungseinheit EE die beiden Spannungswerte Uq1, Uq2 der tatsächlich generierten Gleichspannungen berechnet hat, ermittelt sie anhand dieser beiden Spannungswerte Uq1, Uq2 und der jeweiligen ersten und zweiten Stromesswerte Ia1, Ia2, Ib1, Ib2 der ersten und der zweiten Strommesseinheit ME1, ME2 den Isolationswiderstand R_ISO anhand folgender Gleichung: $R _ ISO = \frac{\left(Uq1-Ia1⋅Ra\right) + \left(Uq1-Ib1⋅Rb\right) - \left(Uq2-Ia2⋅Ra\right) - \left(Uq2-Ib2⋅Ra\right)}{2 ⋅ \left(\left(Ia1-Ia2\right)+\left(Ib1-Ib2\right)\right)}$

Dabei sind Ra und Rb der jeweilige Widerstandswert der jeweiligen Ankopplungswiderstände Ra, Rb und R_ISO der Widerstandswert des Isolationswiderstands R_ISO.

Anschließend überprüft die Ermittlungseinheit EE optional die Genauigkeit des ermittelten Isolationswiderstands R_ISO anhand der Strommesswerte Ic1, Ic2 der dritten Strommesseinheit ME3, welche nicht zum Ermitteln des Isolationswiderstands R_ISO herangezogen wurden.

Alternativ kann die Ermittlungseinheit EE zur Ermittlung des Isolationswiderstands R_ISO anstelle der Strommesswerte Ia1, Ia2 der ersten Strommesseinheit ME1 oder der Strommesswerte Ib1, Ib2 der zweiten Strommesseinheit ME2 die Strommesswerte Ic1, Ic2 der dritten Strommesseinheit ME3 verwenden. In diesem Fall sind jedoch geringfügige Anpassungen bei der obigen Gleichung durch eine Umrechnung zwischen den Strommesswerten Ia1, Ia2, Ib1, Ib2, Ic1 und Ic2 basierend auf folgenden Gleichungen erforderlich: $Ic 1 = Ia 1 + Ib 1$ $Ic 2 = Ia 2 + Ib 2$

Die Strommesswerte Ia1, Ia2, Ib1, Ib2 der ersten oder der zweiten Strommesseinheit ME1, ME2, die nicht zur Ermittlung des Isolationswiderstands R_ISO herangezogen wurden, können dann zur Überprüfung des ermittelten Isolationswiderstands R_ISO verwendet werden.

Der ermittelte Isolationswiderstand R ISO wird anschließend mit einem vorgegebenen Referenzwiderstand R_REF verglichen. Überschreitet der ermittelte Isolationswiderstand R_ISO den Referenzwiderstand R_REF, so wird davon ausgegangen, dass die elektrische Isolation in dem Bordnetz BN bzw. zwischen dem Hochvoltbordnetzzweig HZ und dem Rest des Bordnetzes BN bzw. der elektrischen Masse MA ausreichend hoch ist und entsprechende Sicherheitsanforderungen erfüllt.

Sobald der ermittelte Isolationswiderstand R ISO den Referenzwiderstand R_REF unterschreitet, dann wird von einem elektrischen Leck zwischen dem Hochvoltbordnetzzweig HZ und dem Rest des Bordnetzes BN bzw. der elektrischen Masse MA ausgegangen. Entsprechend werden die Traktionsbatterie BT durch gesteuertes Öffnen der drei Schütze Sc1, Sc2, Sc3 von dem Hochvoltbordnetzzweig HZ elektrisch getrennt und der Zwischenkreiskondensator Czk bis auf eine Ladespannung unter 60 Volt entladen sowie weitere geeigneten Maßnahmen eingeleitet.

Es können bei jeweiligem Verfahrensschritt S300 bzw. S500 auch mehrere Strom- und Spannungsmesswerte für die jeweiligen Ströme Ia, Ib, Ic und der Spannung U2 hintereinander gemessen und aus den mehreren Messwerten Mittelwerte für die jeweiligen Strommesswerte Ia1, Ia2, Ib1, Ib2, Ic1, Ic2 und die jeweiligen Spannungsmesswerte U21, U22 gebildet werden. Dadurch werden mögliche Störungen wie Stromschwankungen im Bordnetz BN herausgefiltert und somit wird die Genauigkeit bei dem ermittelten Isolationswiderstand R_ISO erhöht.

In einer alternativen Ausführungsform werden die zuvor gemessenen Strommesswerte Ia1, Ib2 bei Überschreiten des Grenzwertes durch die Abweichung zwischen dem ersten und dem zweiten Betriebsspannungswert Ub1, Ub2 nicht verworfen. In dieser Ausführungsform wird der Isolationswiderstand R_ISO aus den ersten und den zweiten Strommesswerten Ia1, Ib1, Ia2 und Ib2 sowie dem ersten und dem zweiten Spannungsmesswert U21, U22 anhand der obigen Gleichungen ermittelt und um einen Korrekturfaktor korrigiert.

Hierzu wird ein entsprechender Korrekturfaktor abhängig von der Abweichung aus einer im Vorfeld ermittelten Korrekturfaktor-Tabelle abgelesen. Der berechnete Isolationswiderstand wird dann um diesen Korrekturfaktor korrigiert. Der so gewonnene korrigierte Isolationswiderstandswert wird dann als aktueller Isolationswiderstand R_ISO des Hochvoltbordnetzzweigs HZ mit dem Referenzwiderstandswert verglichen.

Ist die Ermittlung abgeschlossen, so öffnet die Steuereinheit SE die beiden Schalter S1, S2 und trennt somit die Vorrichtung V von dem Bordnetz BN bzw. dem Hochvoltbordnetzzweig HZ.

## Patentansprüche

1. Vorrichtung (V) zur Überwachung einer elektrischen Isolation bei einem Bordnetz (BN) eines Fahrzeugs, die folgende Merkmale aufweist:
- eine Spannungsquelle (SQ) zum Generieren einer ersten Gleichspannung mit einem ersten Spannungswert (Uq1),
- einen Stromanschlusspunkt (SP), über den eine positive Stromversorgungsleitung (LP) des Bordnetzes (BN) und eine negative Stromversorgungsleitung (LN) des Bordnetzes (BN) miteinander elektrisch verbunden sind,
- wobei die Spannungsquelle (SQ) zwischen elektrischer Masse (MA) und dem Stromanschlusspunkt (SP) geschaltet ist,
- einen ersten Strompfad (Pa) zwischen der positiven Stromversorgungsleitung (LP) und dem Stromanschlusspunkt (SP),
- einen zweiten Strompfad (Pb) zwischen der negativen Stromversorgungsleitung (LN) und dem Stromanschlusspunkt (SP),
- einen dritten Strompfad (Pc) zwischen dem Stromanschlusspunkt (SP) und der Spannungsquelle (SQ),
- zumindest zwei der folgenden drei Strommesseinheiten:
• einer ersten Strommesseinheit (ME1) in dem ersten Strompfad (Pa) zum Messen eines ersten, durch den ersten Strompfad (Pa) fließenden Stromes (Ia),
• einer zweiten Strommesseinheit (ME2) in dem zweiten Strompfad (Pb) zum Messen eines zweiten, durch den zweiten Strompfad (Pc) fließenden Stromes (Ib),
• einer dritten Strommesseinheit (ME3) in dem dritten Strompfad (Pc) zum Messen eines dritten, durch den dritten Strompfad (Pc) fließenden Stromes (Ic),
- wobei die zumindest zwei der drei Strommesseinheiten ferner eingerichtet sind, jeweils einen ersten Strommesswert (Ia1, Ib1) des ersten (Ia) und des zweiten (Ib), unter Einwirkung der ersten Gleichspannung jeweils durch einen der Strompfade (Pa, Pb) fließenden Stromes zu messen,
- eine Ermittlungseinheit (EE), die über Signaleingänge (SE1, SE2, SE3) mit jeweiligem Signalausgang (SA1, SA2, SA3) der zumindest zwei der drei Strommesseinheiten (ME1, ME2, ME3) elektrisch verbunden ist,
**dadurch gekennzeichnet, dass**
- die Spannungsquelle (SQ) ferner zum Generieren einer zweiten Gleichspannung mit einem zweiten Spannungswert (Uq2) eingerichtet ist,
- wobei die zumindest zwei der drei Strommesseinheiten ferner eingerichtet sind, jeweils einen zweiten Strommesswert (Ia2, Ib2) des ersten (Ia) und des zweiten (Ib), unter Einwirkung der zweiten Gleichspannung durch den jeweiligen Strompfad (Pa, Pb) fließenden Stromes zu messen,
- wobei die Ermittlungseinheit (EE) eingerichtet ist, aus Strommesswerten (Ia1, Ia2, Ib1, Ib2) der zumindest zwei der drei Strommesseinheiten (ME1, ME2, ME3) sowie dem ersten (Uq1) und dem zweiten (Uq2) Spannungswert einen Isolationswiderstand (R_ISO) zwischen dem Bordnetz (BN) und elektrischer Masse (MA) zu ermitteln,
- wobei die Ermittlungseinheit (EE) ferner eingerichtet ist, den Isolationswiderstand als Quotient aus der Differenz zwischen dem ersten (Uq1) und dem zweiten (Uq2) Spannungswert korrigiert um die jeweiligen an jeweiligen Widerständen (Ra, Rb) der jeweiligen Strompfade (Pa, Pb) abfallenden Spannungswerten (Ra^{∗}Ia1, Ra^{∗}Ia2, Rb^{∗}Ib1, Rb^{∗}Ib2), und der Differenz zwischen den ersten (Ia1, Ib1) und den zweiten (Ia2, Ib2) Stromwerten zu berechnen.

2. Vorrichtung (V) nach Anspruch 1, wobei die Vorrichtung (V) alle drei Strommesseinheiten (ME1, ME2, ME3) umfasst, wobei die Ermittlungseinheit (EE) über die Signaleingänge (SE1, SE2, SE3) mit dem jeweiligen Signalausgang (SA1, SA2, SA3) der drei Strommesseinheiten (ME1, ME2, ME3) elektrisch verbunden ist.

3. Vorrichtung (V) nach Anspruch 1 oder 2, wobei die Vorrichtung (V) in dem ersten Strompfad (Pa) einen ersten Widerstand (Ra) zum Begrenzen des ersten (Ia) und/oder des dritten (Ic) Stromes aufweist, und/oder in dem zweiten Strompfad (Pb) einen zweiten Widerstand (Rb) zum Begrenzen des zweiten (Ib) und/oder des dritten (Ic) Stromes aufweist.

4. Vorrichtung (V) nach einem der vorangehenden Ansprüche, wobei die Vorrichtung (V) in dem ersten Strompfad (Pa) einen ersten steuerbaren Schalter (S1) zum Unterbrechen oder Herstellen elektrischer Verbindung in dem ersten Strompfad (Pa) aufweist, und/oder in dem zweiten Strompfad (Pb) einen zweiten steuerbaren Schalter (S2) zum Unterbrechen oder Herstellen elektrischer Verbindung in dem zweiten Strompfad (Pb) aufweist.

5. Vorrichtung (V) nach einem der vorangehenden Ansprüche, wobei der erste Spannungswert (Uq1) 50 bis 60 Volt und/oder der zweite Spannungswert (Uq2) -60 bis -50 Volt betragen.

6. Bordnetz (BN) für ein Fahrzeug, wobei das Bordnetz (BN) eine Vorrichtung (V) nach einem der vorangehenden Ansprüche zur Überwachung der elektrischen Isolation bei dem Bordnetz (BN) aufweist.

7. Fahrzeug mit einem Bordnetz (BN), wobei das Bordnetz (BN) eine Vorrichtung (V) nach einem der Ansprüche 1 bis 5 zur Überwachung der elektrischen Isolation bei dem Bordnetz (BN) aufweist.

8. Verfahren zur Überwachung einer elektrischen Isolation bei einem Bordnetz (BN) eines Fahrzeugs, wobei das Verfahren folgende Verfahrensschritte aufweist:
- Schalten (S100) einer Spannungsquelle (SQ) zwischen elektrischer Masse (MA) und einem Stromanschlusspunkt (SP), über den eine positive Stromversorgungsleitung (LP) des Bordnetzes (BN) und eine negative Stromversorgungsleitung (LN) des Bordnetzes (BN) miteinander elektrisch verbunden sind;
- erstes Generieren (S200) einer ersten Gleichspannung mit einem ersten Spannungswert (Uq1) mittels der Spannungsquelle (SQ);
- erstes Messen (S300) jeweils eines ersten Strommesswertes (Ia1, Ib1) eines ersten (Ia) und eines zweiten (Ib) Stromes, wobei der erste (Ia) und der zweite (Ib) Strom unter Einwirkung der ersten Gleichspannung jeweils durch einen der folgenden drei Strompfade fließen:
• eines ersten Strompfades (Pa) zwischen der positiven Stromversorgungsleitung (LP) und dem Stromanschlusspunkt (SP),
• eines zweiten Strompfades (Pb) zwischen der negativen Stromversorgungsleitung (LN) und dem Stromanschlusspunkt (SP),
• eines dritten Strompfades (Pc) zwischen dem Stromanschlusspunkt (SP) und der Spannungsquelle (SQ);
**gekennzeichnet durch,**
- zweites Generieren (S400) einer zweiten Gleichspannung mit einem zweiten Spannungswert (Uq2) mittels der Spannungsquelle (SQ);
- zweites Messen (S500) jeweils eines zweiten Strommesswertes (Ia2, Ib2) des ersten (Ia) und des zweiten (Ib), jeweils unter Einwirkung der zweiten Gleichspannung durch den jeweiligen Strompfad (Pa, Pb) fließenden Stromes;
- Ermitteln (S600) eines Isolationswiderstands (R_ISO) zwischen dem Bordnetz (BN) und elektrischer Masse (MA) aus dem ersten (Uq1) und dem zweiten (Uq2) Spannungswert sowie den ersten (Ia1, Ib1) und den zweiten (Ia2, Ib2) Strommesswerten;
- wobei der Isolationswiderstand als Quotient aus der Differenz zwischen dem ersten (Uq1) und dem zweiten (Uq2) Spannungswert korrigiert um die jeweiligen an jeweiligen Widerständen (Ra, Rb) der jeweiligen Strompfade (Pa, Pb) abfallenden Spannungswerten (Ra^{∗}Ia1, Ra^{∗}Ia2, Rb^{∗}Ib1, Rb^{∗}Ib2), und der Differenz zwischen den ersten (Ia1, Ib1) und den zweiten (Ia2, Ib2) Stromwerten berechnet wird.

9. Verfahren nach Anspruch 8, wobei der Isolationswiderstand (R_ISO) anhand folgender Gleichung ermittelt wird: $R _ ISO = \frac{\left(Uq1-Ia1⋅Ra\right) + \left(Uq1-Ib1⋅Rb\right) - \left(Uq2-Ia2⋅Ra\right) - \left(Uq2-Ib2⋅Ra\right)}{n ⋅ \left(\left(Ia1-Ia2\right)+\left(Ib1-Ib2\right)\right)}$ wobei
n ein Zahlenkoeffizient ist,
Ra und Rb Widerstandswerte in den jeweiligen Strompfaden (Pa, Pb) sind, durch die die jeweiligen Ströme (Ia, Ib) unter Einwirkung der ersten und der zweiten Gleichspannung fließen.

10. Verfahren nach einem der Ansprüche 8 bis 9, wobei
- der Schritt des ersten Messens (S300) ferner vorsieht, dass ein erster Betriebsspannungswert (Uzk1) der Betriebsspannung (Uzk) des Bordnetzes (BN) gemessen wird;
- der Schritt des zweiten Messens (S500) ferner vorsieht, dass ein zweiter Betriebsspannungswert (Uzk2) der Betriebsspannung (Uzk) gemessen wird;
- wobei der erste (Uzk1) und der zweite (Uzk2) Betriebsspannungswert miteinander verglichen werden, wobei bei einer Abweichung zwischen dem ersten (Uzk1) und dem zweiten (Uzk2) Betriebsspannungswert:
• die ersten Strommesswerte (Ia1, Ib1) verworfen werden,
• eine dritte Gleichspannung mit einem dritten Spannungswert (Uq3) mittels der Spannungsquelle (SQ) generiert wird, und
• jeweils ein dritter Strommesswert (Ia3, Ib3) des ersten (Ia) und des zweiten (Ib), jeweils unter Einwirkung der dritten Gleichspannung durch den jeweiligen Strompfad (Pa, Pb) fließenden Stromes gemessen wird; und
- der Schritt des Ermittelns (S600) ferner vorsieht, dass der Isolationswiderstand (R_ISO) aus dem zweiten (Uq2) und dem dritten (Uq3) Spannungswert sowie den zweiten (Ia2, Ib2) und den dritten (Ia3, Ib3) Strommesswerten ermittelt wird.

11. Verfahren nach einem der Ansprüche 8 bis 9, wobei
- der Schritt des ersten Messens (S300) ferner vorsieht, dass ein erster Betriebsspannungswert (Uzk1) der Betriebsspannung (Uzk) gemessen wird;
- der Schritt des zweiten Messens (S500) ferner vorsieht, dass ein zweiter Betriebsspannungswert (Uzk2) der Betriebsspannung (Uzk) gemessen wird;
- wobei der erste (Uzk1) und der zweite (Uzk2) Betriebsspannungswert miteinander verglichen werden, wobei bei einer Abweichung zwischen dem ersten (Uzk1) und dem zweiten (Uzk2) Betriebsspannungswert ein Korrekturfaktor ermittelt wird, und
- der Schritt des Ermittelns (S600) ferner vorsieht, dass der Isolationswiderstand (R_ISO) um den Korrekturfaktor korrigiert wird.

12. Verfahren nach Anspruch 11, wobei der Korrekturfaktor abhängig von der Abweichung zwischen dem ersten (Uzk1) und den zweiten (Uzk2) Betriebsspannungswert aus einer vorab ermittelten Korrekturfaktor-Tabelle abgelesen wird.

13. Verfahren nach einem der Ansprüche 8 bis 12, wobei
- der Schritt des ersten Messens (S300) ferner vorsieht, dass neben den ersten Strommesswerten (Ia1, Ib1) des ersten (Ia) und des zweiten (Ib) Stromes noch ein erster Strommesswert (Ic1) eines dritten, unter Einwirkung der ersten Gleichspannung durch den restlichen Strompfad (Pc) der drei Strompfade fließenden Stromes (Ic) gemessen wird;
- der Schritt des zweiten Messens (S500) ferner vorsieht, dass neben den zweiten Strommesswerten (Ia2, Ib2) des ersten (Ia) und des zweiten (Ib) Stromes noch ein zweiter Strommesswert (Ic2) des dritten, unter Einwirkung der zweiten Gleichspannung durch den restlichen Strompfad (Pc) fließenden Stromes (Ic) gemessen wird;
- wobei der erste (Ic1) und der zweite (Ic2) Strommesswert des dritten Stromes (Ic) zum Überprüfen der Genauigkeit des ermittelten Isolationswiderstands (R_ISO) herangezogen werden.

## Claims

1. Apparatus (V) for monitoring an electrical insulation for an onboard power supply system (BN) of a vehicle, which apparatus has the following features:
- a power source (SQ) for generating a first DC voltage having a first voltage value (Uq1),
- an electrical connection point (SP) via which a positive power supply line (LP) of the onboard power supply system (BN) and a negative power supply line (LN) of the onboard power supply system (BN) are electrically connected to one another,
- wherein the power source (SQ) is wired between electrical earth (MA) and the electrical connection point (SP),
- a first current path (Pa) between the positive power supply line (LP) and the electrical connection point (SP),
- a second current path (Pb) between the negative power supply line (LN) and the electrical connection point (SP),
- a third current path (Pc) between the electrical connection point (SP) and the power source (SQ),
- at least two of the following three current measuring units:
• a first current measuring unit (ME1) in the first current path (Pa) for measuring a first current (Ia) flowing through the first current path (Pa),
• a second current measuring unit (ME2) in the second current path (Pb) for measuring a second current (Ib) flowing through the second current path (Pc),
• a third current measuring unit (ME3) in the third current path (Pc) for measuring a third current (Ic) flowing through the third current path (Pc),
- wherein the at least two of the three current measuring units are also set up to respectively measure a first measured current value (Ia1, Ib1) of the first current (Ia) and of the second current (Ib) flowing through one of the current paths (Pa, Pb) in each case under the effect of the first DC voltage,
- an ascertainment unit (EE) that is electrically connected to the respective signal output (SA1, SA2, SA3) of the at least two of the three current measuring units (ME1, ME2, ME3) via signal inputs (SE1, SE2, SE3), **characterized in that**
- the power source (SQ) is also set up to generate a second DC voltage having a second voltage value (Uq2),
- wherein the at least two of the three current measuring units are also set up to respectively measure a second measured current value (Ia2, Ib2) of the first current (Ia) and of the second current (Ib) flowing through the respective current path (Pa, Pb) under the effect of the second DC voltage,
- wherein the ascertainment unit (EE) is set up to ascertain from measured current values (Ia1, Ia2, Ib1, Ib2) from the at least two of the three current measuring units (ME1, ME2, ME3) and also the first (Uq1) and the second (Uq2) voltage value an insulation resistance (R_ISO) between the onboard power supply system (BN) and electrical earth (MA),
- wherein the ascertainment unit (EE) is also set up to compute the insulation resistance as the quotient of the difference between the first (Uql) and the second (Uq2) voltage value corrected by the respective voltage values (Ra^{∗}Ia1, Ra^{∗}Ia2, Rb^{∗}Ib1, Rb^{∗}Ib2) dropped across respective resistors (Ra, Rb) of the respective current paths (Pa, Pb) and the difference between the first (Ia1, Ib1) and the second (Ia2, Ib2) current values.

2. Apparatus (V) according to Claim 1, wherein the apparatus (V) comprises all three current measuring units (ME1, ME2, ME3), wherein the ascertainment unit (EE) is electrically connected to the respective signal output (SA1, SA2, SA3) of the three current measuring units (ME1, ME2, ME3) via the signal inputs (SE1, SE2, SE3).

3. Apparatus (V) according to Claim 1 or 2, wherein the apparatus (V) has, in the first current path (Pa), a first resistor (Ra) for limiting the first (Ia) and/or the third (Ic) current, and/or has, in the second current path (Pb), a second resistor (Rb) for limiting the second (Ib) and/or the third (Ic) current.

4. Apparatus (V) according to one of the preceding claims, wherein the apparatus (V) has, in the first current path (Pa), a first controllable switch (S1) for breaking or making electrical connection in the first current path (Pa), and/or has, in the second current path (Pb), a second controllable switch (S2) for breaking or making electrical connection in the second current path (Pb).

5. Apparatus (V) according to one of the preceding claims, wherein the first voltage value (Uq1) is 50 to 60 volts and/or the second voltage value (Uq2) is -60 to -50 volts.

6. Onboard power supply system (BN) for a vehicle, wherein the onboard power supply system (BN) has an apparatus (V) according to one of the preceding claims for monitoring the electrical insulation for the onboard power supply system (BN) .

7. Vehicle having an onboard power supply system (BN), wherein the onboard power supply system (BN) has an apparatus (V) according to one of Claims 1 to 5 for monitoring the electrical insulation for the onboard power supply system (BN).

8. Method for monitoring an electrical insulation for an onboard power supply system (BN) of a vehicle, wherein the method has the following method steps:
- wiring (S100) of a power source (SQ) between electrical earth (MA) and an electrical connection point (SP) via which a positive power supply line (LP) of the onboard power supply system (BN) and a negative power supply line (LN) of the onboard power supply system (BN) are electrically connected to one another;
- first generation (S200) of a first DC voltage having a first voltage value (Uq1) by means of the power source (SQ) ;
- first measurement (S300) of a respective first measured current value (Ia1, Ib1) of a first (Ia) and a second (Ib) current, wherein the first (Ia) and the second (Ib) current each flow through one of the following three current paths under the effect of the first DC voltage:
• a first current path (Pa) between the positive power supply line (LP) and the electrical connection point (SP),
• a second current path (Pb) between the negative power supply line (LN) and the electrical connection point (SP),
• a third current path (Pc) between the electrical connection point (SP) and the power source (SQ);
**characterized by**
- second generation (S400) of a second DC voltage having a second voltage value (Uq2) by means of the power source (SQ) ;
- second measurement (S500) of a respective second measured current value (Ia2, Ib2) of the first (Ia) and the second (Ib) current flowing through the respective current path (Pa, Pb) in each case under the effect of the second DC voltage;
- ascertainment (S600) of an insulation resistance (R_ISO) between the onboard power supply system (BN) and electrical earth (MA) from the first (Uq1) and the second (Uq2) voltage value and also the first (Ia1, Ib1) and the second (Ia2, Ib2) measured current values;
- wherein the insulation resistance is computed as the quotient of the difference between the first (Uq1) and the second (Uq2) voltage value corrected by the respective voltage values (Ra^{∗}Ia1, Ra^{∗}Ia2, Rb^{∗}Ib1, Rb^{∗}Ib2) dropped across respective resistors (Ra, Rb) of the respective current paths (Pa, Pb) and the difference between the first (Ia1, Ib1) and the second (Ia2, Ib2) current values.

9. Method according to Claim 8, wherein the insulation resistance (R_ISO) is ascertained on the basis of the following equation: $R _ ISO = \frac{\left(Uq1-Ia1⋅Ra\right) + \left(Uq1-Ib1⋅Rb\right) - \left(Uq2-Ia2⋅Ra\right) - \left(Uq2-Ib2⋅Ra\right)}{n ⋅ \left(\left(Ia1-Ia2\right)+\left(Ib1-Ib2\right)\right)}$ where
n is a numerical coefficient,
Ra and Rb are resistance values in the respective current paths (Pa, Pb) through which the respective currents (Ia, Ib) flow under the effect of the first and second DC voltages.

10. Method according to one of Claims 8 to 9, wherein
- the step of first measurement (S300) further provides for a first operating voltage value (Uzk1) of the operating voltage (Uzk) of the onboard power supply system (BN) to be measured;
- the step of second measurement (S500) further provides for a second operating voltage value (Uzk2) of the operating voltage (Uzk) to be measured;
- wherein the first (Uzk1) and the second (Uzk2) operating voltage value are compared with one another, wherein in the event of a discrepancy between the first (Uzk1) and the second (Uzk2) operating voltage value:
• the first measured current values (Ia1, Ib1) are rejected,
• a third DC voltage having a third voltage value (Uq3) is generated by means of the power source (SQ), and
• a respective third measured current value (Ia3, Ib3) of the first (Ia) and the second (Ib) current flowing through the respective current path (Pa, Pb) in each case under the effect of the third DC voltage is measured; and
- the step of ascertainment (S600) further provides for the insulation resistance (R_ISO) to be ascertained from the second (Uq2) and the third (Uq3) voltage value and also the second (Ia2, Ib2) and the third (Ia3, Ib3) measured current values.

11. Method according to one of Claims 8 to 9, wherein
- the step of first measurement (S300) further provides for a first operating voltage value (Uzk1) of the operating voltage (Uzk) to be measured;
- the step of second measurement (S500) further provides for a second operating voltage value (Uzk2) of the operating voltage (Uzk) to be measured;
- wherein the first (Uzk1) and the second (Uzk2) operating voltage value are compared with one another, wherein in the event of a discrepancy between the first (Uzk1) and the second (Uzk2) operating voltage value, a correction factor is ascertained, and
- the step of ascertainment (S600) further provides for the insulation resistance (R_ISO) to be corrected by the correction factor.

12. Method according to Claim 11, wherein the correction factor is read from a previously ascertained correction factor table on the basis of the discrepancy between the first (Uzk1) and the second (Uzk2) operating voltage value.

13. Method according to one of Claims 8 to 12, wherein
- the step of first measurement (S300) further provides for not only the first measured current values (Ia1, Ib1) of the first (Ia) and the second (Ib) current but also a first measured current value (Ic1) of a third current (Ic) flowing through the remaining current path (Pc) of the three current paths under the effect of the first DC voltage to be measured;
- the step of second measurement (S500) further provides for not only the second measured current values (Ia2, Ib2) of the first (Ia) and the second (Ib) current but also a second measured current value (Ic2) of the third current (Ic) flowing through the remaining current path (Pc) under the effect of the second DC voltage to be measured;
- wherein the first (Ic1) and the second (Ic2) measured current value of the third current (Ic) are used to check the accuracy of the ascertained insulation resistance (R_ISO).

## Revendications

1. Dispositif (V) servant à surveiller une isolation électrique d'un réseau de bord (BN) d'un véhicule, présentant les particularités suivantes :
- une source de tension (SQ) pour produire une première tension continue ayant une première valeur de tension (Uq1),
- un point de connexion de courant (SP) reliant électriquement entre elles une ligne d'alimentation en courant positive (LP) du réseau de bord (BN) et une ligne d'alimentation en courant négative (LN) du réseau de bord (BN),
- la source de tension (SQ) étant connectée entre la masse électrique (MA) et le point de connexion de courant (SP),
- un premier trajet de courant (Pa) entre la ligne d'alimentation en courant positive (LP) et le point de connexion de courant (SP),
- un deuxième trajet de courant (Pb) entre la ligne d'alimentation en courant négative (LN) et le point de connexion de courant (SP),
- un troisième trajet de courant (Pc) entre le point de connexion de courant (SP) et la source de tension (SQ),
- au moins deux des trois unités de mesure de courant suivantes :
• une première unité de mesure de courant (ME1) dans le premier trajet de courant (Pa) pour mesurer un premier courant (Ia) passant par le premier trajet de courant (Pa),
• une deuxième unité de mesure de courant (ME2) dans le deuxième trajet de courant (Pb) pour mesurer un deuxième courant (Ib) passant par le deuxième trajet de courant (Pc),
• une troisième unité de mesure de courant (ME3) dans le troisième trajet de courant (Pc) pour mesurer un troisième courant (Ic) passant par le troisième trajet de courant (Pc),
- dans lequel les au moins deux des trois unités de mesure de courant sont en outre aménagées pour mesurer respectivement une première valeur de mesure de courant (Ia1, Ib1) du premier (Ia) et du deuxième (Ib) courant passant par l'un des trajets de courant (Pa, Pb) respectivement sous l'effet de la première tension continue,
- une unité de détermination (EE) qui est reliée électriquement par des entrées de signal (SE1, SE2, SE3) à la sortie de signal respective (SA1, SA2, SA3) des au moins deux des trois unités de mesure de courant (ME1, ME2, ME3), **caractérisé en ce que**
- la source de tension (SQ) est en outre aménagée pour produire une deuxième tension continue ayant une deuxième valeur de tension (Uq2),
- les au moins deux des trois unités de mesure de courant étant en outre aménagées pour mesurer respectivement une deuxième valeur de mesure de courant (Ia2, Ib2) du premier (Ia) et du deuxième (Ib) courant passant par le trajet de courant respectif (Pa, Pb) sous l'effet de la deuxième tension continue,
- l'unité de détermination (EE) étant aménagée pour déterminer à partir des valeurs de mesure de courant (Ia1, Ia2, Ib1, Ib2) des au moins deux des trois unités de mesure de courant (ME1, ME2, ME3) ainsi que de la première (Uq1) et de la deuxième (Uq2) valeur de tension une résistance d'isolation (R_ISO) entre le réseau de bord (BN) et la masse électrique (MA),
- l'unité de détermination (EE) étant en outre aménagée pour calculer la résistance d'isolation comme un quotient de la différence entre la première (Uq1) et la deuxième (Uq2) valeur de tension, corrigée des valeurs de tension (Ra^{∗}Ia1, Ra^{∗}Ia2, Rb^{∗}Ib1, Rb^{∗}Ib2) respectives qui retombent au niveau des résistances (Ra, Rb) respectives des trajets de courant (Pa, Pb) respectifs, et de la différence entre les premières (Ia1, Ib1) et les deuxièmes (Ia2, Ib2) valeurs de courant.

2. Dispositif (V) selon la revendication 1, dans lequel le dispositif (V) comprend l'ensemble des trois unités de mesure de courant (ME1, ME2, ME3), l'unité de détermination (EE) étant reliée électriquement par les entrées de signal (SE1, SE2, SE3) à la sortie de signal (SA1, SA2, SA3) respective des trois unités de mesure de courant (ME1, ME2, ME3).

3. Dispositif (V) selon la revendication 1 ou 2, dans lequel le dispositif (V) présente dans le premier trajet de courant (Pa) une première résistance (Ra) pour limiter le premier (Ia) et/ou le troisième (Ic) courant, et/ou présente sur le deuxième trajet de courant (Pb) une deuxième résistance (Rb) pour limiter le deuxième (Ib) et/ou le troisième (Ic) courant.

4. Dispositif (V) selon l'une quelconque des revendications précédentes, dans lequel le dispositif (V) présente dans le premier trajet de courant (Pa) un premier commutateur commandé (S1) pour interrompre ou établir une connexion électrique dans le premier trajet de courant (Pa), et/ou présente dans le deuxième trajet de courant (Pb) un deuxième commutateur commandé (S2) pour interrompre ou établir une connexion électrique dans le deuxième trajet de courant (Pb).

5. Dispositif (V) selon l'une quelconque des revendications précédentes, dans lequel la première valeur de tension (Uq1) est comprise entre 50 et 60 volts et/ou la deuxième valeur de tension (Uq2) est comprise entre -60 et -50 volts.

6. Réseau de bord (BN) pour un véhicule, dans lequel le réseau de bord (BN) présente un dispositif (V) selon l'une quelconque des revendications précédentes pour surveiller l'isolation électrique du réseau de bord (BN).

7. Véhicule équipé d'un réseau de bord (BN), dans lequel le réseau de bord (BN) présente un dispositif (V) selon l'une quelconque des revendications 1 à 5 pour surveiller l'isolation électrique du réseau de bord (BN).

8. Procédé de surveillance d'une isolation électrique d'un réseau de bord (BN) d'un véhicule, le procédé présentant les étapes de procédé suivantes :
- la connexion (S100) d'une source de tension (SQ) entre la masse électrique (MA) et un point de connexion de courant (SP) reliant électriquement entre elles une ligne d'alimentation en courant positive (LP) du réseau de bord (BN) et une ligne d'alimentation en courant négative (LN) du réseau de bord (BN) ;
- une première production (S200) d'une première tension continue d'une première valeur de tension (Uq1) au moyen de la source de tension (SQ) ;
- une première mesure (S300) respectivement d'une première valeur de mesure de courant (Ia1, Ib1) d'un premier (Ia) et d'un deuxième (Ib) courant, le premier (Ia) et le deuxième (Ib) courant passant sur l'un des trois trajets de courant suivants respectivement, sous l'effet de la première tension continue :
• un premier trajet de courant (Pa) entre la ligne d'alimentation en courant positive (LP) et le point de connexion de courant (SP),
• un deuxième trajet de courant (Pb) entre la ligne d'alimentation en courant négative (LN) et le point de connexion de courant (SP),
• un troisième trajet de courant (Pc) entre le point de connexion de courant (SP) et la source de tension (SQ) ;
**caractérisé par**
- une deuxième production (S400) d'une deuxième tension continue d'une deuxième valeur de tension (Uq2) au moyen de la source de tension (SQ) ;
- une deuxième mesure (S500) respectivement d'une deuxième valeur de mesure de courant (Ia2, Ib2) du premier (Ia) et du deuxième (Ib) courant passant par le trajet de courant (Pa, Pb) respectif, sous l'effet de la deuxième tension continue ;
- la détermination (S600) d'une résistance d'isolation (R_ISO) entre le réseau de bord (BN) et la masse électrique (MA) à partir de la première (Uq1) et de la deuxième (Uq2) valeur de tension ainsi que des premières (Ia1, Ib1) et des deuxièmes (Ia2, Ib2) valeurs de mesure de courant ;
- la résistance d'isolation étant calculée comme un quotient de la différence entre la première (Uq1) et la deuxième (Uq2) valeur de tension corrigée des valeurs de tension (Ra^{∗}Ia1, Ra^{∗}Ia2, Rb^{∗}Ib1, Rb^{∗}Ib2) respectives qui retombent au niveau des résistances (Ra, Rb) respectives des trajets de courant (Pa, Pb) respectifs, et de la différence entre les premières (Ia1, Ib1) et les deuxièmes (Ia2, Ib2) valeurs de courant.

9. Procédé selon la revendication 8, dans lequel la résistance d'isolation (R_ISO) est déterminée à l'aide de l'équation suivante : $R _ ISO = \frac{\left(Uq1-Ia1⋅Ra\right) + \left(Uq1-Ib1⋅Rb\right) - \left(Uq2-Ia2⋅Ra\right) - \left(Uq2-Ib2⋅Ra\right)}{n ⋅ \left(\left(Ia1-Ia2\right)+\left(Ib1-Ib2\right)\right)}$ où
n est un coefficient numérique,
Ra et Rb sont des valeurs de résistance dans les trajets de courant (Pa, Pb) respectifs par lesquels passent les courants (Ia, Ib) respectifs sous l'effet de la première et de la deuxième tension continue.

10. Procédé selon l'une quelconque des revendications 8 à 9, dans lequel
- l'étape de la première mesure (S300) prévoit en outre de mesurer une première valeur de tension de régime (Uzk1) de la tension de régime (Uzk) du réseau de bord (BN) ;
- l'étape de la deuxième mesure (S500) prévoit en outre de mesurer une deuxième valeur de tension de régime (Uzk2) de la tension de régime (Uzk) ;
- dans lequel la première (Uzk1) et la deuxième (Uzk2) valeur de tension de régime sont comparées l'une à l'autre, dans lequel, en cas d'écart entre la première (Uzk1) et la deuxième (Uzk2) valeur de tension de régime :
• les premières valeurs de mesure de courant (Ia1, Ib1) sont rejetées,
• une troisième tension continue d'une troisième valeur de tension (Uq3) est produite au moyen de la source de tension (SQ), et
• respectivement une troisième valeur de mesure de courant (Ia3, Ib3) du premier (Ia) et du deuxième (Ib) courant passant par le trajet de courant (Pa, Pb) respectif sous l'effet de la troisième tension continue est mesurée ; et
- l'étape de détermination (S600) prévoit en outre de déterminer la résistance d'isolation (R_ISO) à partir de la deuxième (Uq2) et de la troisième (Uq3) valeur de tension ainsi que des deuxièmes (Ia2, Ib2) et des troisièmes (Ia3, Ib3) valeurs de mesure de courant.

11. Procédé selon l'une quelconque des revendications 8 à 9, dans lequel
- l'étape de la première mesure (S300) prévoit en outre de mesurer une première valeur de tension de régime (Uzk1) de la tension de régime (Uzk) ;
- l'étape de la deuxième mesure (S500) prévoit en outre de mesurer une deuxième valeur de tension de régime (Uzk2) de la tension de régime (Uzk) ;
- dans lequel la première (Uzk1) et la deuxième (Uzk2) valeur de tension de régime sont comparées l'une à l'autre, dans lequel, en cas d'écart entre la première (Uzk1) et la deuxième (Uzk2) valeur de tension de régime, un facteur de correction est déterminé, et
- l'étape de la détermination (S600) prévoit en outre de corriger la résistance d'isolation (R_ISO) avec le facteur de correction.

12. Procédé selon la revendication 11, dans lequel le facteur de correction est lu dans une table de facteurs de correction préalablement déterminée en fonction de l'écart entre la première (Uzk1) et la deuxième (Uzk2) valeur de tension de régime.

13. Procédé selon l'une quelconque des revendications 8 à 12, dans lequel
- l'étape de la première mesure (S300) prévoit en outre de mesurer en plus des premières valeurs de mesure de courant (Ia1, Ib1) du premier (Ia) et du deuxième (Ib) courant également une première valeur de mesure de courant (Ic1) d'un troisième courant (Ic) passant par le trajet de courant restant (Pc) des trois trajets de courant, sous l'effet de la première tension continue ;
- l'étape de la deuxième mesure (S500) prévoit en outre de mesurer en plus des deuxièmes valeurs de mesure de courant (Ia2, Ib2) du premier (Ia) et du deuxième (Ib) courant également une deuxième valeur de mesure de courant (Ic2) du troisième courant (Ic) passant par le trajet de courant (Pc) restant, sous l'effet de la deuxième tension continue ;
- dans lequel la première (Ic1) et la deuxième (Ic2) valeur de mesure de courant du troisième courant (Ic) sont utilisées pour vérifier la justesse de la résistance d'isolation (R_ISO) déterminée.
